# EUROPEAN PATENT SPECIFICATION

(11) **EP 3 146 808 B1**
(45) Date of publication and mention of the grant of the patent: **31.10.2018**
(21) Application number: 15729232.7
(22) Date of filing: 12.05.2015
(51) Int. Cl.: H05K 1/03, H05K 1/05, B32B 5/02, B32B 7/12, B32B 15/04, B32B 15/08, B32B 15/14, B32B 15/18, B32B 15/20, B32B 27/20, B32B 27/28

(54) **CIRCUIT ASSEMBLIES AND METHOD OF MANUFACTURE THEREOF**
SCHALTUNGSANORDNUNGEN UND VERFAHREN ZUR HERSTELLUNG DAVON
ENSEMBLES CIRCUIT ET PROCÉDÉ POUR LES FABRIQUER

(30) Priority: 22.05.2014 US 201462001843 P
(43) Date of publication of application: 29.03.2017
(73) Proprietor: SABIC Global Technologies B.V., 4612 PX Bergen op Zoom (NL)
(72) Inventor: YANG, Jian, Shanghai 2013019 (CN); PAN, Shengping, Shanghai 2013019 (CN); VAN ZYL, Andries J.P., NL-4612 PX Bergen op Zoom (NL)
(74) Representative: Office Freylinger
(86) International application number: PCT/IB2015/053498
(87) International publication number: WO 2015/177684

(56) References cited:
- JP-A- H0 645 715
- US-A1- 2008 268 266
- US-A1- 2009 035 591

## Description

### BACKGROUND

This disclosure is directed to circuit assemblies, in particular assemblies containing a polyetherimide dielectric layer.

Circuit assemblies for the manufacture of printed circuit boards (PCBs) also known as printed wiring boards (PWBs), including metal core PCBs (MCPCBs) and multilayer circuits, are well known in the art. In general, circuit assemblies comprise a dielectric layer, an electrically conductive metal layer such as copper, and a supporting metal matrix layer such as aluminum for heat dissipation, where the dielectric layer is disposed between the conductive metal layer and the supporting metal matrix layer. The conductive metal layer can be laminated, adhered, sputtered, or plated onto the dielectric layer. The dielectric layer generally includes a polymer, such as a cross-linked epoxy, or a polyimide. The dielectric layer can further contain fibrous reinforcement, such as a woven or nonwoven glass, and inorganic fillers. The circuit assemblies can then be subjected to a series of steps to leave a circuitized metal pattern on the dielectric layer. The circuitized pattern serves to connect the various electronic components that can be added to make the desired electronic device. Such circuitized layers can be used alone or in a multilayer stack having interlayer connections.

Dielectric materials for use in circuit materials and circuit boards have been the subject of intensive research and development. Nonetheless there remains a continuing need in the art for improved dielectric compositions. In many electronic applications, the electronic components frequently generate heat, and it is desirable that the circuit board contribute to heat dissipation. Such materials should further have improved heat conductivity and be tolerant of high processing temperatures, soldering temperatures, and operating temperatures, since a thermal gradient will usually exist between the warmer interior of the equipment and the ambient surroundings. Preferred materials would thus possess high heat resistance, excellent dimensional and thermal stability, and chemical resistance. Preferred materials should further exhibit excellent electrical properties, including a high use temperature, high processing/soldering temperature, a low dielectric constant, good flexibility, and adhesion to metal surfaces. It would be a further processing advantage if the dielectric compositions could be directly cast on the metal layer by solvent casting, or extruded into films using solvent-free processes such as melt extrusion. Preferred dielectric compositions can further comprise thermally conductive or electrically conductive fillers, and the dielectric layer should be relatively thin (<100 micrometers) for good heat conductivity.

US 2009/035591 A1 discloses a flexible laminate comprising ULTEM® polyetherimide in a dielectric layer having a thickness of 50 micrometers but further comprising AURUM® polyimide having a glass transition temperature of 258°C in said layer.

### BRIEF DESCRIPTION

A circuit assembly as defined by claim 1.

A method of preparing the circuit assembly comprises laminating the polyetherimide dielectric layer to the conductive metal layer and to the supporting metal matrix layer under heat and pressure; wherein the conductive metal layer and the supporting metal matrix layer are disposed on opposite sides of the polyetherimide dielectric layer. In an embodiment, one or more polyetherimide dielectric layers are thermally extruded. In another embodiment, one more polyetherimide dielectric layers are prepared by preparing a casting solution comprising the polyetherimide and a solvent; casting a layer of the casting solution onto a substrate; and removing solvent from the layer of casting solution. The layers can be directly cast onto the supporting metal matrix metal layer or the conductive layer, or both.

Articles comprising the circuit assemblies are also disclosed.

The above described and other features are exemplified by the following Detailed Description and Examples, and the invention is defined by the Claims.

### DETAILED DESCRIPTION

Described herein are circuit assemblies comprising a conductive metal layer for circuit printing, a supporting metal matrix layer for heat dissipation, and a polyetherimide dielectric layer between the conductive metal layer and the supporting metal matrix layer. The circuit assemblies can further comprise additional metal layer and dielectric layer combinations for complex circuit designs. The inventors hereof have discovered that the use of certain polyetherimides, even those having a glass transition temperature of less than 280°C, in the dielectric layer provides assemblies that maintain excellent adhesion and dimensional stability even after thermal stress at temperatures greater than the glass transition temperature, e.g. at temperatures of greater than 280°C. The circuit assemblies are particularly useful for the preparation of thermally conductive circuit assemblies. The dielectric layers can further have good heat conductivity and electrical insulation, as well as exceptional processability, especially when compared to polyimide and epoxy-based dielectric layers.

The dielectric layers are formed from a dielectric composition comprising a polyetherimide and optional additives as further described below. The polyetherimides have a glass transition temperature (Tg) of 210 to 230°C.

The polyetherimides comprise more than 1, for example 10 to 1000, or 10 to 500, structural units of formula (1) 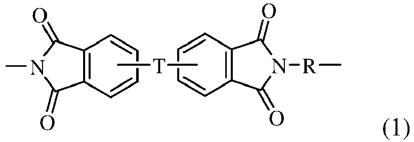 wherein each R is the same or different, and is a substituted or unsubstituted divalent organic group, such as a C₆₋₂₀ aromatic hydrocarbon group or a halogenated derivative thereof, a straight or branched chain C₂₋₂₀ alkylene group or a halogenated derivative thereof, a C₃₋₈ cycloalkylene group or halogenated derivative thereof, in particular a divalent group of formula (2) 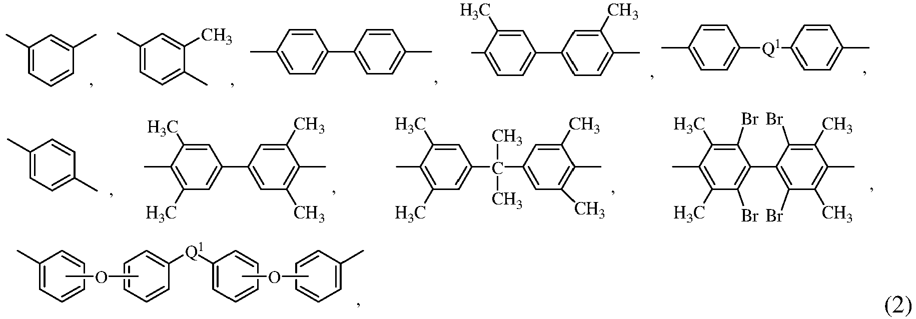 wherein Q¹ is -O-, -S-, -C(O)-, -SO₂-, -SO-, -C_{y}H_{2y}- wherein y is an integer from 1 to 5 or a halogenated derivative thereof (which includes perfluoroalkylene groups), or -(C₆H₁₀)_{z}- wherein z is an integer from 1 to 4. In an embodiment R is m-phenylene or p-phenylene.

Further in formula (1), T is -O- or a group of the formula -O-Z-O- wherein the divalent bonds of the -O- or the -O-Z-O- group are in the 3,3', 3,4', 4,3', or the 4,4' positions. The group Z in -O-Z-O- of formula (1) is also a substituted or unsubstituted divalent organic group, and can be an aromatic C₆₋₂₄ monocyclic or polycyclic moiety optionally substituted with 1 to 6 C₁₋₈ alkyl groups, 1 to 8 halogen atoms, or a combination thereof, provided that the valence of Z is not exceeded. Exemplary groups Z include groups derived from a dihydroxy compound of formula (3) 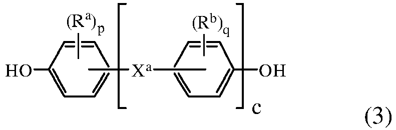 wherein R^{a} and R^{b} can be the same or different and are a halogen atom or a monovalent C₁₋₆ alkyl group, for example; p and q are each independently integers of 0 to 4; c is 0 to 4; and X^{a} is a bridging group connecting the hydroxy-substituted aromatic groups, where the bridging group and the hydroxy substituent of each C₆ arylene group are disposed ortho, meta, or para (specifically para) to each other on the C₆ arylene group. The bridging group X^{a} can be a single bond, -O-, -S-, -S(O)-, -SO₂-, -C(O)-, or a C₁₋₁₈ organic bridging group. The C₁₋₁₈ organic bridging group can be cyclic or acyclic, aromatic or non-aromatic, and can further comprise heteroatoms such as halogens, oxygen, nitrogen, sulfur, silicon, or phosphorous. The C₁₋₁₈ organic group can be disposed such that the C₆ arylene groups connected thereto are each connected to a common alkylidene carbon or to different carbons of the C₁₋₁₈ organic bridging group. A specific example of a group Z is a divalent group of formula (3a) 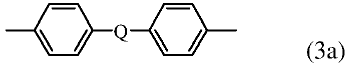 wherein Q is -O-, -S-, -C(O)-, -SO₂-, -SO-, or -C_{y}H_{2y}- wherein y is an integer from 1 to 5 or a halogenated derivative thereof (including a perfluoroalkylene group). In a specific embodiment Z is a derived from bisphenol A, such that Q in formula (3a) is 2,2-isopropylidene.

The polyetherimide optionally comprises up to 10 mole%, up to 5 mole%, or up to 2 mole% of units of formula (1) wherein T is a linker of the formula 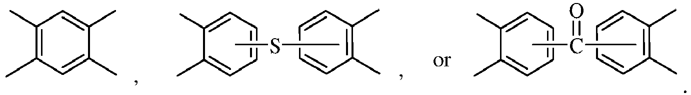 In some embodiments no units are present wherein R is of these formulas. In some embodiments, the polyetherimides have no R groups containing sulfone groups. In certain specific embodiments, no sulfone groups are present in the polyetherimide.

In an embodiment in formula (1), R is m-phenylene or p-phenylene and T is -O-Z-O-wherein Z is a divalent group of formula (3a). Alternatively, R is m-phenylene or p-phenylene and T is -O-Z-O wherein Z is a divalent group of formula (3a) and Q is 2,2-isopropylidene. In this embodiment, it is preferred that the polyetherimides have no R groups containing sulfone groups, or no sulfone groups are present in the polyetherimide.

The polyetherimide can be prepared by any of the methods well known to those skilled in the art, including the reaction of an aromatic bis(ether anhydride) of formula (5) 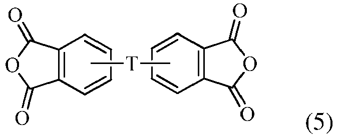 with an organic diamine of formula (6)

H₂N-R-NH₂ (6)

wherein T and R are defined as described above.

Illustrative examples of bis(anhydride)s include 3,3-bis[4-(3,4-dicarboxyphenoxy)phenyl]propane dianhydride; 4,4'-bis(3,4-dicarboxyphenoxy)diphenyl ether dianhydride; 4,4'-bis(3,4-dicarboxyphenoxy)diphenyl sulfide dianhydride; 4,4'-bis(3,4-dicarboxyphenoxy)benzophenone dianhydride; 4,4'-bis(3,4-dicarboxyphenoxy)diphenyl sulfone dianhydride; 2,2-bis[4-(2,3-dicarboxyphenoxy)phenyl]propane dianhydride; 4,4'-bis(2,3-dicarboxyphenoxy)diphenyl ether dianhydride; 4,4'-bis(2,3-dicarboxyphenoxy)diphenyl sulfide dianhydride; 4,4'-bis(2,3-dicarboxyphenoxy)benzophenone dianhydride; 4,4'-bis(2,3-dicarboxyphenoxy)diphenyl sulfone dianhydride; 4-(2,3-dicarboxyphenoxy)-4'-(3,4-dicarboxyphenoxy)diphenyl-2,2-propane dianhydride; 4-(2,3-dicarboxyphenoxy)-4'-(3,4-dicarboxyphenoxy)diphenyl ether dianhydride; 4-(2,3-dicarboxyphenoxy)-4'-(3,4-dicarboxyphenoxy)diphenyl sulfide dianhydride; 4-(2,3-dicarboxyphenoxy)-4'-(3,4-dicarboxyphenoxy)benzophenone dianhydride; and, 4-(2,3-dicarboxyphenoxy)-4'-(3,4-dicarboxyphenoxy)diphenyl sulfone dianhydride, as well as various combinations thereof.

Examples of organic diamines include ethylenediamine, propylenediamine, trimethylenediamine, diethylenetriamine, triethylene tetramine, hexamethylenediamine, heptamethylenediamine, octamethylenediamine, nonamethylenediamine, decamethylenediamine, 1,12-dodecanediamine, 1,18-octadecanediamine, 3-methylheptamethylenediamine, 4,4-dimethylheptamethylenediamine, 4-methylnonamethylenediamine, 5-methylnonamethylenediamine, 2,5-dimethylhexamethylenediamine, 2,5-dimethylheptamethylenediamine, 2, 2-dimethylpropylenediamine, N-methyl-bis (3-aminopropyl) amine, 3-methoxyhexamethylenediamine, 1,2-bis(3-aminopropoxy) ethane, bis(3-aminopropyl) sulfide, 1,4-cyclohexanediamine, bis-(4-aminocyclohexyl) methane, m-phenylenediamine, p-phenylenediamine, 2,4-diaminotoluene, 2,6-diaminotoluene, m-xylylenediamine, p-xylylenediamine, 2-methyl-4,6-diethyl-1,3-phenylene-diamine, 5-methyl-4,6-diethyl-1,3-phenylene-diamine, benzidine, 3,3'-dimethylbenzidine, 3,3'-dimethoxybenzidine, 1,5-diaminonaphthalene, bis(4-aminophenyl) methane, bis(2-chloro-4-amino-3,5-diethylphenyl) methane, bis(4-aminophenyl) propane, 2,4-bis(p-amino-t-butyl) toluene, bis(p-amino-t-butylphenyl) ether, bis(p-methyl-o-aminophenyl) benzene, bis(p-methyl-o-aminopentyl) benzene, 1, 3-diamino-4-isopropylbenzene, bis(4-aminophenyl) sulfide, bis-(4-aminophenyl) sulfone, and bis(4-aminophenyl) ether. Combinations of these compounds can also be used. In some embodiments the organic diamine is m-phenylenediamine, p-phenylenediamine, sulfonyl dianiline, or a combination comprising one or more of the foregoing.

The polyetherimides can have a melt index of 0.1 to 10 grams per minute (g/min), as measured by American Society for Testing Materials (ASTM) D1238 at 340 to 370 °C, using a 6.7 kilogram (kg) weight. In some embodiments, the polyetherimide has a weight average molecular weight (Mw) of 1,000 to 150,000 grams/mole (Daltons), as measured by gel permeation chromatography, using polystyrene standards. In some embodiments the polyetherimide has an Mw of 10,000 to 80,000 Daltons. Such polyetherimides can have an intrinsic viscosity greater than 0.2 deciliters per gram (dl/g), or, more specifically, 0.35 to 0.7 dl/g as measured in m-cresol at 25 °C.

The dielectric layer optionally comprises a thermally conductive filler component. Thermally conductive filler components are selected primarily to provide the material with good thermal conductivity. Useful thermally conductive fillers include boron nitride, aluminum nitride, aluminum oxide, silicon nitride, MgSiN₂, silicon carbide, or a combination comprising at least one of the foregoing. Particles, e.g., of graphite or aluminum oxide coated with any of the foregoing can also be used. Fillers of lower thermal conductivity can also be included, for example zinc sulfide, calcium oxide, magnesium oxide, zinc oxide, titanium oxide, or a combination comprising at least one of the foregoing. Boron nitride, aluminum nitride, aluminum oxide, and combinations comprising at least one of the foregoing are especially useful.

The thermally conductive filler can have an average particle size of 50 nanometers to 50 micrometers, and can be of any shape. The dielectric compositions containing the polyetherimide and the thermally conductive filler component can be mixed enough so that the average particle size of the thermally conductive filler particle is adequately reduced and a stable dispersion is formed. The thermally conductive filler component can be uniformly dispersed so that the average particle size of the filler in an organic solvent compatible with the polymer component (or the polymer component) is greater than 10, 20, 30, 40, or 50 nanometers to less than 1.0, 2.0, 3.0, 5.0, 10, or 20 micrometers. Generally speaking, filler component that is not adequately dispersed (e.g. a filler component that contains large agglomerates) can oftentimes degrade or defeat the functional aspects sought after in the materials.

When present, the amount of thermally conductive filler component in the dielectric layer is 1 to 60 weight percent, or 10 to 50 weight percent, specifically 20 to 40 weight percent, each based on the total weight of the polyetherimide.

Other fillers can be present in the dielectric layer, particularly dielectric fillers such as glass, aluminum oxide, zinc oxide, titanium dioxide, and silica. In some embodiments the amount of dielectric filler component in the polymer matrix is 1 to 60 weight percent, or 10 to 50 weight percent, specifically 20 to 40 weight percent, each based on the total weight of the polyetherimide.

The dielectric layer can optionally comprise a fabric layer. Suitable fabrics can comprise non-woven fabrics or woven fabrics comprising any of the following glass types: E, D, S, R, or a combination comprising at least one of the foregoing. Also suitable is NE type glass available from NittoBoseki Co., Fukushima, Japan. Suitable glass styles include, but are not limited to, 106, 1080, 2112, 2113, 2116, and 7628, wherein the term glass style is known to those skilled in the art and refers to the size of glass fibers and number of fibers in a bundle. In other embodiments fabrics can comprise such materials as aramid such as KEVLAR® aramid available from DuPont, aramid/glass hybrid, or ceramic. In addition, woven fabrics of cellulose fibers can also be used. Fabrics can have a thickness from 5 to 200 micrometers, specifically 10 to 50 micrometers, and more specifically 10 to 40 micrometers. In some embodiments fabric, such as the woven or nonwoven glass fabric can optionally be pretreated before use in assembly of the subassemblies. Illustrative treatment methods for fabrics comprise one or both of chemical treatment such as with a sizing agent or a silane, or physical treatment such as by heat, flame, plasma, or corona treatment.

The circuit assemblies comprise the dielectric layer adhered to a conductive metal layer, in particular a foil. The metal can be adhered to one or both sides of the dielectric layer. Conductive metals include copper, zinc, brass, chrome, nickel, aluminum, stainless steel, iron, gold, silver, titanium, or an alloy containing one or more of these metals. Other useful metals include, but are not limited to, a copper molybdenum alloy, a nickel-cobalt iron alloy such as Kovar®, available from Carpenter Technology Corporation, a nickel-iron alloy such as Invar®, available from National Electronic Alloys, Inc., a bimetal, a trimetal, a tri-metal derived from two-layers of copper and one layer of Invar®, and a trimetal derived from two layers of copper and one layer of molybdenum. In some embodiments suitable metal layers comprise copper or a copper-based alloy. Alternatively, wrought copper foils can be used.

Conductive metal layers in exemplary embodiments can have a thickness of 2 to 200 micrometers, specifically 5 to 50 micrometers, and more specifically 5 to 40 micrometers. In some embodiments, the conductive metal layer is in the form of a circuit.

The circuit assemblies further comprise a heat dissipating metal matrix layer disposed on the dielectric layer on a side opposite the conductive metal layer. Such heat dissipation layers can be metals, in particular thermally conductive metals such as aluminum, boron nitride, aluminum nitride, copper or the like. A thermally conductive, electrically conductive metal can be used provided that the metal is electrically isolated from the metal circuit layer. Preferred supporting metal matrix layers can have a thickness of 0.1 to 20 millimeters, specifically 0.5 to 10 millimeters, and more specifically 0.8 to 2 millimeters.

The MCPCBs having sandwich-type structure provide good heat dissipation and electric isolation from the printed circuit in the conductive metal layer.

Both the conductive metal layer and the supporting metal matrix layers can be pretreated to have high surface roughness for enhanced adhesion to the dielectric layer. In some cases, the dielectric layer can adhere firmly to the conductive metal layer and/or the heat dissipation layer without using an adhesive. In other embodiments, an adhesive can be used to improve adhesion of the dielectric layer to the conductive metal layer and/or the heat dissipation layer. Common adhesives used to bond the composite sheet to a metal (if an adhesive is used) are polyimide-based adhesives, acrylic-based adhesives, or epoxies.

General techniques for preparing the dielectric composition and the dielectric layer are known to those skilled in the art. The polyetherimide component can be first dissolved in a suitable solvent, to prepare a solution. A number of solvents can be used, depending on various factors, e. g., their boiling point; and the manner in which the polyetherimide is going to be incorporated into a dielectric layer. Non-limiting examples of the solvents are as follows: methylene chloride, chloroform, ortho-dichlorobenzene (ODCB); N,N-dimethylformamide (DMF); N-methyl-2-pyrrolidone (NMP); veratrole (1,2-dimethoxybenzene); nitromethane, and various combinations of these solvents. The solution containing the polymer can be combined with any optional fillers, and coated onto a substrate to form a dielectric polymer film. Examples of coating processes include, but are not limited to, tape-casting, dip coating, spin coating, chemical vapor deposition, and physical vapor deposition, such as sputtering. In some embodiments, the film can be applied by a solvent casting process. When the film thickness is substantially small, solution based coating techniques such as spin coating or dip coating can be used.

When a fabric is present, the solution containing the polymer and any optional fillers can be impregnated into the fabric by dipping or coating. Alternatively, the dielectric composition without solvent can be melted, combined with any optional fillers, and impregnated into the fabric to provide the dielectric layer. In still another embodiment a layer consisting of the polyetherimide and any optional fillers are thermally laminated under heat and pressure to form the dielectric layer. When lamination is used, a first and second layer consisting of the polyetherimide and any optional fillers can be disposed on opposite sides of the fabric and laminated. Conditions for lamination can vary depending on the particular polyetherimide, optional filler, and like considerations, and can be for example, 280 to 350°C under no less than 1 MPa of pressure for 5 to 180 minutes.

The circuit assemblies can be made by thermal lamination of one or more dielectric layers, one or more conductive metal layers, and a supporting metal matrix layer, under pressure without using thermosetting adhesives. The dielectric layer can be prepared prior to the thermal lamination step by a solvent-free process such as melt extrusion, or by a solvent casting process. In some embodiments, the polyetherimide dielectric layer, the conductive metal layer, and the heat dissipation layer are thermally laminated together by an adhesive-free process under pressure to form a laminate. In an embodiment, a polyetherimide layer is placed between the electrically conductive metal layer and a layer of woven fabric, and thermally laminated under pressure in a single step. The electrically conductive metal layer can optionally be in the form of a circuit before laminating. Alternatively, the conductive metal layer can optionally be etched to form the electrical circuit following lamination. The laminating can be by hot press or roll calendaring methods, i.e., a roll-to-roll method.

Alternatively, the circuit assemblies can be made by a solution casting method in which the polyetherimide is dissolved in a solvent and cast directly onto the electrically conductive metal layer, followed by lamination to the heat dissipating metal matrix layer. The polyetherimide solution can alternatively be cast directly onto the heat dissipating metal matrix layer, followed by lamination to the electrically conductive metal layer. In this embodiment the polyetherimide layer can be referred to as a "varnish."

Multilayer assemblies comprising additional layers can also be made by thermal lamination in one step or in two or more consecutive steps by such processes as hot press or roll calendaring methods. In some embodiments seven layers or fewer can be present in the laminate and in other embodiments sixteen layers or fewer. For example, in an exemplary embodiment a laminate can be formed in one step or in two or more consecutive steps with sequential layers of fabric-polyetherimide-metal-polyetherimide-fabric-polyetherimide-metal foil or a subcombination thereof with fewer layers, such that the laminate comprises a layer of polyetherimide film between any layer of metal foil and any layer of fabric. In another embodiment a first laminate can be formed in one step or in two or more consecutive steps with a layer of fabric between two layers of polyetherimide, such as a layer of woven glass fabric between two layers of polyetherimide. A second laminate can then be prepared by laminating a metal foil to a polyetherimide side of the first laminate.

The circuit assemblies can have an overall thickness of 0.1 to 20 millimeters and specifically 0.5 to 10 millimeters, wherein overall thickness refers to an assembly comprising a layer each of the polyetherimide dielectric layer, the electrically conductive metal layer, and the supporting metal matrix layer. Circuit assemblies in some particular embodiments have an overall thickness of 0.5 to 2 millimeters and specifically 0.5 to 1.5 millimeters. There is no particular limitation on the thickness of the polyetherimide dielectric layer as long as a desired overall thickness of the laminate is achieved. In some embodiments the thickness of the polyetherimide dielectric layer is 5 to 1500 micrometers, specifically 5 to 750 micrometers, more specifically 10 to 150 micrometers, and even more specifically 10 to 100 micrometers.

The polyetherimide dielectric layer can have a dielectric strength of 80 to 150 KV/mm, or 90 to 120 KV/mm, or 100 to 110 KV/mm.

The polyetherimide dielectric layer can have a breakdown voltage of 1 to 10 kV, or 3 to 8 kV, or 4 to 6 kV.

The circuit assembly can have a peel strength of 1 to 3, or 1.3 to 1.8, as determined in accordance with IPC-TM-650 test methods.

The circuit assembly can have a thermal impedance of 0.1 to 3 °C cm²/watt.

The circuit assembly has the same adhesion, within + 10%, as determined by IPC-TM-650 test methods, before and after thermal stress at 280°C for 30 minutes in accordance with SJ 20780-2000. The circuit assembly further does not display "popcorning" after thermal stress at 280°C for 30 minutes.

Articles comprising the circuit assemblies formed by circuitizing at least one of the conductive metal layers are another aspect of the disclosure. Articles include those comprising printed circuits as used in medical or aerospace industries. Still other articles include antennae and like articles. In other embodiments such articles include, but are not limited to, those comprising printed circuit boards, which are used, for example, in lighting, displays, cameras, audio and video equipment, personal computers, mobile telephones, electronic notepads, and like devices, or office automation equipment. In other embodiments electrical parts can be mounted on printed circuit boards comprising a laminate.

In some embodiments, the present disclosure provides a method of preparing a circuit material and circuit board that does not require a step of applying or curing an adhesive.

The polyetherimide-containing circuit boards provided are inexpensive, reliable, demonstrate good processability, and are compatible with materials and manufacturing processes in which circuit boards are used. The disclosed sandwich-type structure provides good heat dissipation and electric isolation of the printed circuit in the conductive metal layer. The circuit boards are furthermore suitable for non-flat PCB/lighting designs compared to conventional circuit boards. Therefore, a substantial improvement in printed circuit boards and their assembly is provided.

### EXAMPLES

Materials for the following examples are listed in Table 1.

**Table 1.**

| Component | Chemical Description | Source |
|---|---|---|
| PEI | Polyetherimide made via reaction of bisphenol-A dianhydride with equimolar amount of m-phenylene diamine, having a glass transition temperature of 217°C. | SABIC |

The circuit assembly of example 1 (E1) was prepared by an adhesive-free thermal lamination process using a polyetherimide having a glass transition temperature of 217°C. The polyetherimide film was prepared by thermal extrusion. The polyetherimide dielectric layer had a thickness of 50 micrometers. Copper was used as the conductive metal circuit layer and aluminum was used as the heat dissipating supporting metal matrix layer. The polyetherimide dielectric layer was laminated between the conductive metal circuit layer and the supporting metal matrix layer so as to electrically isolate the metal circuit layer, using a hot press at 300 - 320°C under no less than 1 MPa of pressure for 60 minutes. The properties of the circuit assembly of example 1 are compared to several conventional circuit assemblies having dielectric layers comprising glass (C1), epoxy film (C2), DuPont CooLam LX03517016RA (C3), and DuPont CooLam LX07022016RA (C4) in Table 2.

**Table 2.**

| Examples | | C1 | C2 | C3 | C4 | E1 |
|---|---|---|---|---|---|---|
| Dielectric Layer (thickness) | | Conventional Glass Laminate (100 um) | Epoxy Film (100 um) | Dupont CooLam¹ (17 um) | Dupont CooLam² (22 um) | PEI Film (50 um) |
| Properties | | | | | | |
| Heat Conductivity | W/m-K | 3 | 3 | 0.8/0.7 | 0.8/0.7 | 0.24 |
| Thermal Impedance | °C cm²/watt | | | 0.24 | 0.31 | 2.08 |
| Heat Resistance | °C*in²/W | 0.08 | 0.08 | 0.06 | 0.06 | 0.394 |
| Dielectric Voltage | KV/mil (DC) | 2000 | 1500 | 2000 | 2000 | |
| Dielectric Voltage | KV/mm | | | 170 | 197 | 105 |
| Water Absorption | % | 0.5-0.8 | 0.8-1.0 | 1.0-1.5 | 1.0-1.5 | 0.25 |
| Tg | °C | 130 | 130 | > 300 | > 300 | 217 |
| Peel strength | Kgf/cm | 1.4∼1.6 | 1.2∼1.4 | 2.5 | 2.5 | 1.53/1.57 |
| Breakdown Voltage | kV | | | 2.5 | 4 | 5 |

| | | | | | | |
|---|---|---|---|---|---|---|
| ¹DuPont CooLam LX03517016RA; ²DuPont CooLam LX07022016RA | | | | | | |

The results shown in Table 2 demonstrate that a circuit assembly can be prepared by an adhesive-free process with a polyetherimide dielectric layer, a copper metal circuit layer, and an aluminum supporting metal matrix layer, where the polyetherimide has a glass transition temperature above 200°C, but less than the processing temperature. The circuit assembly demonstrates good adhesion, with a high peeling strength of 1.53/1.57 Kgf/cm. Furthermore, the circuit assemblies have good heat conductivity as a result of the use of a thin PEI layer, and/or the incorporation of thermally conductive fillers. Surprisingly, the circuit assemblies can withstand high temperatures (up to 280°C) for 30 minutes, retaining good adhesion between the layers of the assembly, despite the use of a polyetherimide having a glass transition temperature of only 217°C. The circuit assembly prepared according to example 1 further did not display the phenomenon known in the art as "popcorning." The circuit assemblies of the present disclosure have exceptional processability owing to the use of a low Tg polyetherimide, yet retain the desired properties required for a circuit assembly, and therefore represent a substantial improvement in printed circuit boards and their manufacture.

In general, the circuit assemblies can alternately comprise, consist of, or consist essentially of, any appropriate components herein disclosed. The circuit assemblies can additionally, or alternatively, be formulated so as to be devoid, or substantially free, of any components, materials, ingredients, adjuvants or species used in the prior art compositions or that are otherwise not necessary to the achievement of the function and/or objectives of the present embodiments.

All ranges disclosed herein are inclusive of the endpoints, and the endpoints are independently combinable with each other. "Combination" is inclusive of blends, mixtures, alloys, reaction products, and the like. Furthermore, the terms "first," "second," and the like, herein do not denote any order, quantity, or importance, but rather are used to denote one element from another. The terms "a" and "an" and "the" herein do not denote a limitation of quantity, and are to be construed to cover both the singular and the plural, unless otherwise indicated herein or clearly contradicted by context. "Or" means "and/or" unless clearly

The term "alkyl" includes branched or straight chain, unsaturated aliphatic C₁₋₃₀ hydrocarbon groups e.g., methyl, ethyl, n-propyl, i-propyl, n-butyl, s-butyl, t-butyl, n-pentyl, s-pentyl, n- and s-hexyl, n-and s-heptyl, and, n- and s-octyl. "Alkenyl" means a straight or branched chain, monovalent hydrocarbon group having at least one carbon-carbon double bond (e.g., ethenyl (-HC=CH₂)). "Alkoxy" means an alkyl group that is linked via an oxygen (i.e., alkyl-O-), for example methoxy, ethoxy, and sec-butyloxy groups.

"Alkylene" means a straight or branched chain, saturated, divalent aliphatic hydrocarbon group (e.g., methylene (-CH₂-) or, propylene (-(CH₂)₃-)).

"Cycloalkylene" means a divalent cyclic alkylene group, -CₙH₂ₙ₋ₓ, wherein x represents the number of hydrogens replaced by cyclization(s). "Cycloalkenyl" means a monovalent group having one or more rings and one or more carbon-carbon double bonds in the ring, wherein all ring members are carbon (e.g., cyclopentyl and cyclohexyl).

The term "aryl" means an aromatic hydrocarbon group containing the specified number of carbon atoms, such as to phenyl, tropone, indanyl, or naphthyl.

The prefix "halo" means a group or compound including one more of a fluoro, chloro, bromo, iodo, and astatino substituent. A combination of different halo groups (e.g., bromo and fluoro) can be present. In an embodiment only chloro groups are present.

The prefix "hetero" means that the compound or group includes at least one ring member that is a heteroatom (e.g., 1, 2, or 3 heteroatom(s)), wherein the heteroatom(s) is each independently N, O, S, or P.

"Substituted" means that the compound or group is substituted with at least one (e.g., 1, 2, 3, or 4) substituents independently selected from, a C₁₋₉ alkoxy, a C₁₋₉ haloalkoxy, a nitro (-NO₂), a cyano (-CN), a C₁₋₆ alkyl sulfonyl (-S(=O)₂-alkyl), a C₆₋₁₂ aryl sulfonyl (-S(=O)₂-aryl)a thiol (-SH), a thiocyano (-SCN), a tosyl (CH₃C₆H₄SO₂-), a C₃₋₁₂ cycloalkyl, a C₂₋₁₂ alkenyl, a C₅₋₁₂ cycloalkenyl, a C₆₋₁₂ aryl, a C₇₋₁₃ arylalkylene, a C₄₋₁₂ heterocycloalkyl, and a C₃₋₁₂ heteroaryl instead of hydrogen, provided that the substituted atom's normal valence is not exceeded.

While particular embodiments have been described, alternatives, modifications, variations, improvements, and substantial equivalents that are or can be presently unforeseen can arise to applicants or others skilled in the art. Accordingly, the appended claims define the invention.

## Claims

1. A circuit assembly comprising,
a polyetherimide dielectric layer having a thickness of 10 to 100 micrometers consisting of a polyetherimide having a glass transition temperature of 210 to 230°C and optionally one or more components selected from the group consisting of a thermally conductive filler, a dielectric filler and a woven or non-woven fabric;
a conductive metal layer disposed on the dielectric layer; and
a supporting metal matrix layer disposed on the dielectric layer on a side opposite the conductive metal layer;
wherein the circuit assembly has the same adhesion, within + 10%, as determined by IPC-TM-650 test methods, before and after thermal stress at 280°C for 30 minutes in accordance with SJ 20780-2000.

2. The circuit assembly of claim 1, wherein the polyetherimide comprises units of the formula 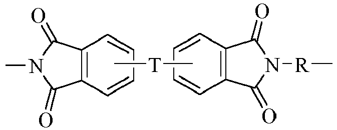 wherein
R is a C₂₋₂₀ hydrocarbon group,
T is -O- or a group of the formula -O-Z-O- wherein the divalent bonds of the -O- or the - O-Z-O- group are in the 3,3', 3,4', 4,3', or the 4,4' positions, and
Z is an aromatic C₆₋₂₄ monocyclic or polycyclic group optionally substituted with 1 to 6 C₁₋₈ alkyl groups, 1-8 halogen atoms, or a combination comprising at least one of the foregoing.

3. The circuit assembly of claim 2, wherein R is a divalent group of the formula 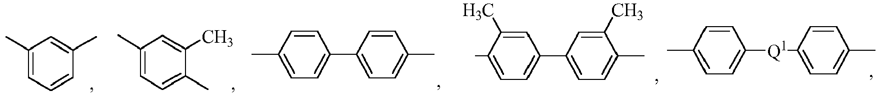 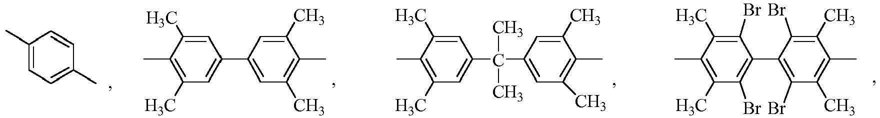 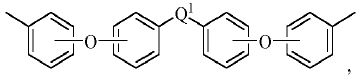 wherein Q¹ is -O-, -S-, -C(O)-, -SO₂-, -SO-, -C_{y}H_{2y}- and a halogenated derivative thereof wherein y is an integer from 1 to 5, and s), or -(C₆H₁₀)_{z}- wherein z is an integer from 1 to 4; and
Z is a group derived from a dihydroxy compound of formula 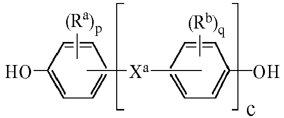 wherein
R^{a} and R^{b} are each independently a halogen atom or a monovalent C₁₋₆ alkyl group;
p and q are each independently integers of 0 to 4;
c is 0 to 4; and
X^{a} is a single bond, -O-, -S-, -S(O)-, -SO₂-, -C(O)-, or a C₁₋₁₈ organic bridging group

4. The circuit assembly of any one or more of claims 1 to 3, wherein the polyetherimide dielectric layer comprises a thermally conductive filler.

5. The circuit assembly of any one or more of claims 1 to 4, wherein the polyetherimide dielectric layer comprises a dielectric filler.

6. The circuit assembly of any one or more of claims 1 to 5, wherein the polyetherimide dielectric layer comprises a woven fabric.

7. The circuit assembly of any one or more of claims 1 to 6, wherein the conductive metal layer comprises copper, zinc, brass, chrome, nickel, aluminum, stainless steel, iron, gold, silver, titanium, or a combination comprising at least one of the foregoing and has a thickness of 2 to 200 micrometers.

8. The circuit assembly of any one or more of claims 1 to 7, wherein the supporting metal matrix layer comprises aluminum and has a thickness of 0.1 to 20 millimeters.

9. The circuit assembly of any one or more of claims 1 to 8, further comprising an adhesive layer disposed between the dielectric layer and the metal circuit layer and an adhesive layer disposed between the dielectric layer and the supporting metal matrix layer.

10. The circuit assembly of any one or more of claims 1 to 9, wherein the conductive metal layer is in the form of a circuit.

11. An article comprising the circuit assembly of claim 10.

12. A method of preparing the circuit assembly of any one or more of claims 1 to 10, the method comprising
laminating the polyetherimide dielectric layer to the conductive metal layer and to the supporting metal matrix layer under heat and pressure;
wherein the conductive metal layer and the supporting metal matrix layer are disposed on opposite sides of the polyetherimide dielectric layer.

13. The method of claim 12, wherein the polyetherimide dielectric layer is thermally extruded.

14. The method of claim 12 or 13, wherein the polyetherimide dielectric layer is prepared by a method comprising
preparing a casting solution comprising the polyetherimide and a solvent;
casting a layer of the casting solution onto a substrate; and
removing solvent from the layer of casting solution.

15. The method of claim 14, wherein the substrate is the conductive metal layer or the supporting metal matrix layer.

## Patentansprüche

1. Schaltungsanordnung mit
einer dielektrischen Polyetherimidschicht mit einer Dicke von 10 bis 100 Mikrometern, bestehend aus einem Polyetherimid mit einer Glasübergangstemperatur von 210 bis 230 °C und gegebenenfalls einer oder mehreren Komponenten, ausgewählt aus der Gruppe bestehend aus einem Wärme leitenden Füllstoff, einem dielektrischen Füllstoff und einem gewebten oder nicht gewebten Stoff,
einer leitenden Metallschicht, angeordnet auf der dielektrischen Schicht, und einer tragenden Metallmatrixschicht, angeordnet auf der dielektrischen Schicht auf einer der leitenden Metallschicht gegenüberliegenden Seite,
wobei die Schaltungsanordnung die gleiche Adhäsion innerhalb von ± 10% aufweist, wie bestimmt durch IPC-TM-650-Testverfahren, vor und nach thermischer Belastung bei 280 °C für 30 Minuten gemäß SJ 20780-2000.

2. Schaltungsanordnung nach Anspruch 1, wobei das Polyetherimid Einheiten enthält der Formel 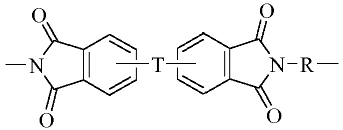 wobei
R eine C₂₋₂₀-Kohlenwasserstoffgruppe ist,
T -O- oder eine Gruppe der Formel -O-Z-O- ist, wobei die zweiwertigen Bindungen der -O- oder der -O-Z-O-Gruppe in den Positionen 3,3', 3,4', 4,3' oder 4,4' liegen und
Z eine aromatische monozyklische oder polyzyklische C₆₋₂₄-Gruppe ist, die gegebenenfalls mit 1 bis 6 C₁₋₈-Alkylgruppen, 1-8 Halogenatomen oder einer Kombination aus mindestens einem des Vorstehenden substituiert ist.

3. Schaltungsanordnung nach Anspruch 2, wobei R eine zweiwertige Gruppe ist der Formel 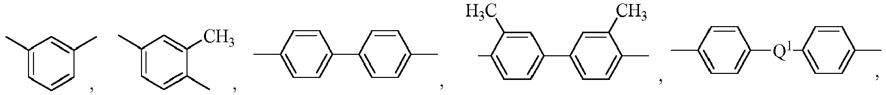 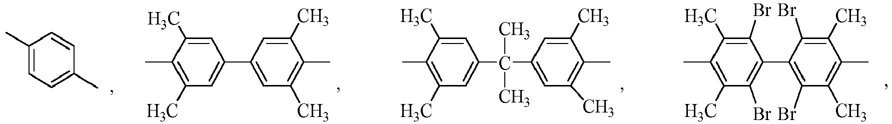 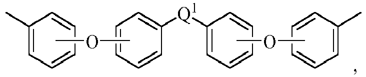 wobei Q¹ -O-, -S-, -C(O)-, -SO₂-, -SO-, -C_{y}H_{2y}- und ein halogeniertes Derivat davon ist,
wobei y eine ganze Zahl von 1 bis 5 und s) oder -(C₆H₁₀)_{z}- ist, wobei z eine ganze Zahl von 1 bis 4 ist, und
Z eine Gruppe ist, abgeleitet von einer Dihydroxyverbindung der Formel 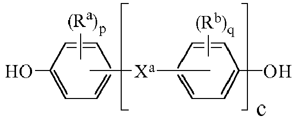 wobei
R^{a} und R^{b} jeweils unabhängig voneinander ein Halogenatom oder eine einwertige C₁₋₆-Alkylgruppe sind, p und q jeweils unabhängig voneinander ganzen Zahlen von 0 bis 4 sind,
c 0 bis 4 ist und
X^{a} eine Einfachbindung, -O-, -S-, -S(O)-, -SO₂-, -C(O)- oder eine organische C₁₋₁₈-Brückengruppe ist.

4. Schaltungsanordnung nach einem oder mehreren der Ansprüche 1 bis 3, wobei die dielektrische Polyetherimidschicht einen Wärme leitenden Füllstoff enthält.

5. Schaltungsanordnung nach einem oder mehreren der Ansprüche 1 bis 4, wobei die dielektrische Polyetherimidschicht einen dielektrischen Füllstoff enthält.

6. Schaltungsanordnung nach einem oder mehreren der Ansprüche 1 bis 5, wobei die dielektrische Polyetherimidschicht einen gewebten Stoff enthält.

7. Schaltungsanordnung nach einem oder mehreren der Ansprüche 1 bis 6, wobei die leitende Metallschicht Kupfer, Zink, Messing, Chrom, Nickel, Aluminium, Edelstahl, Eisen, Gold, Silber, Titan oder eine Verbindung aus mindestens einem der Vorgenannten enthält und eine Dicke von 2 bis 200 Mikrometer aufweist.

8. Schaltungsanordnung nach einem oder mehreren der Ansprüche 1 bis 7, wobei die tragende Metallmatrixschicht Aluminium enthält und eine Dicke von 0,1 bis 20 Millimetern aufweist.

9. Schaltungsanordnung nach einem oder mehreren der Ansprüche 1 bis 8, ferner enthaltend eine Adhäsionsschicht, angeordnet zwischen der dielektrischen Schicht und der metallischen Schaltungsschicht, und eine Adhäsionsschicht, angeordnet zwischen der dielektrischen Schicht und der tragenden Metallmatrixschicht.

10. Schaltungsanordnung nach einem oder mehreren der Ansprüche 1 bis 9, wobei die leitende Metallschicht in Form einer Schaltung vorliegt.

11. Gegenstand, enthaltend die Schaltungsanordnung nach Anspruch 10.

12. Verfahren zum Vorbereiten der Schaltungsanordnung nach einem oder mehreren der Ansprüche 1 bis 10, wobei das Verfahren enthält:
Laminieren der dielektrischen Polyetherimidschicht auf die leitende Metallschicht und auf die tragende Metallmatrixschicht unter Hitze und Druck,
wobei die leitende Metallschicht und die tragende Metallmatrixschicht auf gegenüberliegenden Seiten der dielektrischen Polyetherimidschicht angeordnet sind.

13. Verfahren nach Anspruch 12, wobei die dielektrische Polyetherimidschicht thermisch extrudiert wird.

14. Verfahren nach Anspruch 12 oder 13, wobei die dielektrische Polyetherimidschicht durch folgendes Verfahren hergestellt wird:
Herstellen einer Gießlösung, die das Polyetherimid und ein Lösungsmittel enthält, Gießen einer Schicht der Gießlösung auf ein Substrat, und
Entfernen des Lösungsmittels aus der Schicht der Gießlösung.

15. Verfahren nach Anspruch 14, wobei das Substrat die leitende Metallschicht oder die tragende Metallmatrixschicht ist.

## Revendications

1. Ensemble circuit comprenant
une couche diélectrique de polyétherimide ayant une épaisseur de 10 à 100 micromètres constituée d'un polyétherimide ayant une température de transition vitreuse de 210 à 230 °C et éventuellement un ou plusieurs composants choisis dans le groupe constitué par une charge thermoconductrice, une charge diélectrique et un tissu tissé ou non tissé ;
une couche métallique conductrice disposée sur la couche diélectrique ; et
une couche de matrice métallique de support disposée sur la couche diélectrique sur un côté opposé à la couche de métal conducteur ;
dans lequel l'ensemble circuit a la même adhérence, à ± 10 %, que celle déterminée par les méthodes d'essai IPC-TM-650, avant et après une contrainte thermique à 280 °C pendant 30 minutes conformément à SJ 20780-2000.

2. Ensemble circuit selon la revendication 1, dans lequel le polyétherimide comprend des motifs de formule 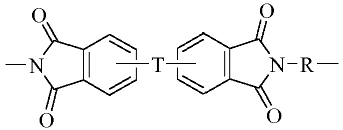 dans laquelle
R est un groupe hydrocarboné en C₂₋₂₀,
T est -O- ou un groupe de formule -O-Z-O- dans lequel les liaisons divalentes de -O- ou du groupe -O-Z-O- sont aux positions 3,3', 3,4', 4,3', ou aux positions 4,4', et
Z est un groupe monocyclique ou polycyclique aromatique en C₆₋₂₄ éventuellement substitué par 1 à 6 groupes alkyle en C₁₋₈, 1 à 8 atomes d'halogène, ou une combinaison comprenant au moins l'un des éléments précédents.

3. Ensemble circuit selon la revendication 2, dans lequel R est un groupe divalent de formule 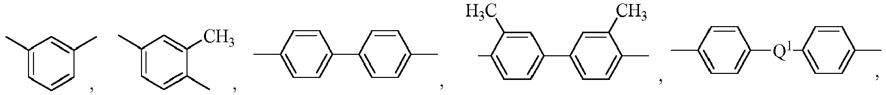 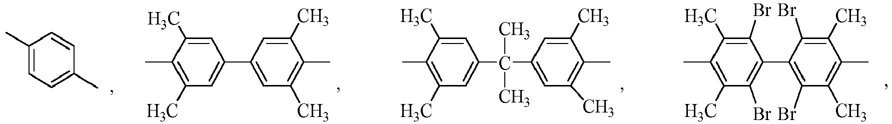 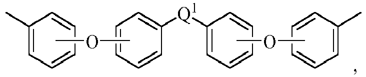 dans laquelle Q¹ est -O-, -S-, -C(O)-, -SO₂-, -SO-, -C_{y}H_{2y}- et un dérivé halogéné de celui-ci
dans lequel y est un nombre entier de 1 à 5, et s), ou -(C₆H₁₀)_{z}- dans lequel z est un nombre entier compris entre 1 et 4 ; et
Z est un groupe dérivé d'un composé dihydroxy de formule 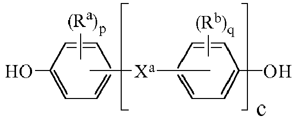 dans laquelle
R^{a} et R^{b} sont chacun indépendamment un atome d'halogène ou un groupe alkyle en C₁₋₆ monovalent ;
p et q sont chacun indépendamment des nombres entiers compris entre 0 et 4 ;
c est 0 à 4 ; et
X^{a} est une liaison simple, -O-, -S-, -S(O)-, -SO₂-, -C(O)-, ou un groupe de pontage organique en C₁₋₁₈.

4. Ensemble circuit selon l'une quelconque ou plusieurs des revendications 1 à 3, dans lequel la couche diélectrique de polyétherimide comprend une charge thermoconductrice.

5. Ensemble circuit selon l'une quelconque ou plusieurs des revendications 1 à 4, dans lequel la couche diélectrique de polyétherimide comprend une charge diélectrique.

6. Ensemble circuit selon l'une quelconque ou plusieurs des revendications 1 à 5, dans lequel la couche diélectrique de polyétherimide comprend un tissu tissé.

7. Ensemble circuit selon l'une quelconque ou plusieurs des revendications 1 à 6, dans lequel la couche de métal conducteur comprend du cuivre, du zinc, du laiton, du chrome, du nickel, de l'aluminium, de l'acier inoxydable, du fer, de l'or, de l'argent, du titane, ou une combinaison comprenant au moins l'un des métaux précédents et a une épaisseur de 2 à 200 micromètres.

8. Ensemble circuit selon l'une quelconque ou plusieurs des revendications 1 à 7, dans lequel la couche de matrice métallique de support comprend de l'aluminium et a une épaisseur de 0,1 à 20 millimètres.

9. Ensemble circuit selon l'une quelconque ou plusieurs des revendications 1 à 8, comprenant en outre une couche adhésive disposée entre la couche diélectrique et la couche de circuit métallique et une couche adhésive disposée entre la couche diélectrique et la couche de matrice métallique de support.

10. Ensemble circuit selon l'une quelconque ou plusieurs des revendications 1 à 9, dans lequel la couche de métal conducteur est sous la forme d'un circuit.

11. Article comprenant l'ensemble circuit selon la revendication 10.

12. Procédé de préparation de l'ensemble circuit selon l'une quelconque ou plusieurs des revendications 1 à 10,
le procédé comprenant
la stratification de la couche diélectrique de polyétherimide sur la couche de métal conducteur et sur la couche de matrice métallique de support sous l'effet de la chaleur et de la pression ;
dans lequel la couche de métal conducteur et la couche de matrice métallique de support sont disposées sur les côtés opposés de la couche diélectrique de polyétherimide.

13. Procédé selon la revendication 12, dans lequel la couche diélectrique de polyétherimide est extrudée à chaud.

14. Procédé selon la revendication 12 ou 13, dans lequel la couche diélectrique de polyétherimide est préparée par un procédé comprenant la préparation d'une solution de coulée comprenant le polyétherimide et un solvant ;
la coulée d'une couche de la solution de coulée sur un substrat ; et l'élimination du solvant de la couche de solution de coulée.

15. Procédé selon la revendication 14, dans lequel le substrat est la couche de métal conducteur ou la couche de matrice métallique de support.
